# EUROPEAN PATENT SPECIFICATION

(11) **EP 3 828 941 B1**
(45) Date of publication and mention of the grant of the patent: **08.05.2024**
(21) Application number: 20167913.1
(22) Date of filing: 03.04.2020
(51) Int. Cl.: H01L 33/38, H01L 33/44, H01L 33/24, H01L 25/075

(54) **METHOD OF MANUFACTURING A LED DEVICE**
VERFAHREN ZUR HERSTELLUNG EINER LED-VORRICHTUNG
PROCÉDÉ DE FABRICATION D'UN DISPOSITIF À DEL

(30) Priority: 26.11.2019 KR 20190153553
(43) Date of publication of application: 02.06.2021
(73) Proprietor: Samsung Electronics Co., Ltd., Gyeonggi-do 16677 (KR); Seoul National University R&DB Foundation, Seoul 08826 (KR)
(72) Inventor: HWANG, Kyungwook, Gyeonggi-do 16678 (KR); KANG, Sungjin, Gyeonggi-do 16678 (KR); YOON, Euijoon, Seoul 08826 (KR); HWANG, Junsik, Gyeonggi-do 16678 (KR); KIM, Jongmyeong, Seoul 08826 (KR); OH, Jehong, Seoul 08826 (KR); RYU, Jungel, Seoul 08826 (KR); LEE, Seungmin, Seoul 08826 (KR)
(74) Representative: Elkington and Fife LLP

(56) References cited:
- WO-A1-2016/122725
- US-A1- 2003 189 215
- US-A1- 2011 211 607
- US-A1- 2012 273 794

## Description

### FIELD OF THE INVENTION

The disclosure relates to a method of manufacturing an LED device.

### BACKGROUND OF THE INVENTION

As display apparatuses, liquid crystal display (LCD) and organic light-emitting diode (OLED) displays are widely used. Recently, a technique for manufacturing a high-resolution display apparatus using a micro-size LED device has drawn attention.

Document US 2011/0211607 A1 discloses a nitride semiconductor including a GaN layer having a (0001) plane and a plane other than the (0001) plane; and an InGaN layer which contacts the GaN layer and includes indium.

Document US 2012/0273794 A1 discloses a semiconductor light emitting device including a first semiconductor layer, an active layer, and a second semiconductor layer.

### SUMMARY OF THE INVENTION

The invention is defined by the claims.

The disclosure provides a method of manufacturing an LED device.

According to an aspect of the disclosure, there is provided a method of manufacturing a light-emitting diode (LED) device according to claim 4.

The method may further comprise: forming a second opening in the passivation layer at a portion of a bottom surface of the first semiconductor layer by removing the membrane.

The method may further comprise: forming a concave-convex structure on the second portion of the bottom surface of the first semiconductor layer, before forming the first electrode.

### BRIEF DESCRIPTION OF THE DRAWINGS

The above and other aspects, features, and advantages of certain example embodiments of the disclosure will be more apparent from the following description taken in conjunction with the accompanying drawings, in which:
FIG. 1 is a cross-sectional view of a light-emitting diode (LED) device
   manufactured according to an example embodiment;
FIG. 2 is a cross-sectional view of an LED device manufactured according to another example embodiment;
FIG. 3 is a cross-sectional view of an LED device manufactured according to another example embodiment;
FIG. 4 is a plane view schematically illustrating a display apparatus comprising a LED device manufactured according to an example embodiment;
FIGS. 5 to 17 are diagrams for describing a method of manufacturing an LED device, according to an example embodiment; and
FIGS. 18-31 are diagrams for describing a method of manufacturing an LED device, according to another example embodiment.

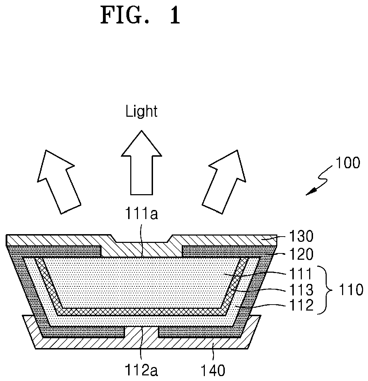

The LED devices described in figures 1-4 are not within the scope of the invention.

### DETAILED DESCRIPTION

Hereinafter, example embodiments of the disclosure will be described in detail with reference to the accompanying drawings. In the drawings, like reference numerals refer to like elements and a size of each element may be exaggerated for clarity and convenience of a description. Meanwhile, the following example embodiments of the disclosure are merely illustrative, and various modifications may be possible from the example embodiments of the disclosure.

Hereinbelow, an expression "above" or "on" may include not only "immediately on in a contact manner", but also "on in a non-contact manner". The singular forms are intended to include the plural forms as well, unless the context clearly indicates otherwise. When a part "includes" a component, this description, unless other specific writing is presented, does not mean to exclude other components but means to further include other components.

The term "the" and a similar indicating term similar thereto may correspond to both a singular form and a plural form. Unless there is a clear disclosure of the order of operations of a method or an otherwise disclosure, the operations may be performed in a proper order. The order of the operations is not limited to the order the operations are mentioned.

The term used in the embodiments such as "unit" or "module" indicates a unit for processing at least one function or operation, and may be implemented in hardware, software, or in a combination of hardware and software.

The connecting lines, or connectors shown in the various figures presented are intended to represent exemplary functional relationships and/or physical or logical couplings between the various elements.

The use of all examples or an exemplary term is intended to simply describe the technical aspects in detail, and the range is not limited by the examples or the exemplary term unless defined by the claims.

FIG. 1 is a cross-sectional view of a light-emitting diode (LED) device manufactured according to an example embodiment.

Referring to FIG. 1, an LED device 100 has a vertical-type electrode structure. More specifically, the LED device 100 includes a light-emitting layer 110, a first electrode 130 and a second electrode 140. The first electrode 130 is provided above the light-emitting layer 110 and the second electrode 140 is provided below the light-emitting layer 110. Herein, the light-emitting layer 110 includes an LED layer based on an inorganic material.

The light-emitting layer 110 has a core-shell structure. The core-shell structure means a structure in which a shell provided in an outer side encloses a core provided in an inner side. According to an example embodiment, the light-emitting layer 110 may have a core-shell structure in which a part of the core is not covered with the shell, but is opened. According to an example embodiment, a top surface of the core may not be covered with the shell and may be open. The light-emitting layer 110 includes a first semiconductor layer 111, an active layer 113, and a second semiconductor layer 112. The first semiconductor layer 111 corresponds to the core of the core-shell structure, and has a three-dimensional (3D) shape having a relatively thick thickness compared to the active layer 113 and the second semiconductor layer 112.

The first semiconductor layer 111 may include, for example, an n-type semiconductor. However, the disclosure is not limited thereto, and depending on circumstances, the first semiconductor layer 111 may include a p-type semiconductor. For example, the first semiconductor layer 111 may include an n-type semiconductor of III-V group, e.g., an n-type nitride semiconductor. Herein, the nitride semiconductor may include, but is not limited to, e.g., GaN, InN, AlN, or a combination thereof. For example, the first semiconductor layer 111 may include n-GaN. The first semiconductor layer 111 may have a single-layer or multi-layer structure.

The active layer 113 and the second semiconductor layer 112 correspond to the shell of the core-shell structure, and have a relatively thin thickness compared to the first semiconductor layer 111. The active layer 113 is provided to cover a bottom surface and a side surface of the first semiconductor layer 111 having a 3D shape, and the second semiconductor layer 112 is provided to cover the active layer 113. Thus, a top surface of the first semiconductor layer 111 is not covered with the active layer 113 and the second semiconductor layer 112, but is opened.

The active layer 113 may generate light of a specific wavelength band through combination of electrons and holes. The active layer 113 may have a multi-quantum well (MQW) structure. However, the disclosure is not limited thereto, and depending on circumstances, the active layer 113 may have a single-quantum well (SQW) structure. The active layer 113 may include a semiconductor of III-V group, e.g., a nitride semiconductor. For example, the active layer 113 may include GaN.

The second semiconductor layer 112 may be provided to cover the active layer 113. The second semiconductor layer 112 may include, for example, a p-type semiconductor. However, the disclosure is not limited thereto, and depending on circumstances, the second semiconductor layer 112 may include an n-type semiconductor. The second semiconductor layer 112 may include a p-type semiconductor of III-V group, e.g., a p-type nitride semiconductor. For example, the second semiconductor layer 112 may include p-GaN. The second semiconductor layer 112 may have a single-layer or multi-layer structure.

The light-emitting layer 110 having the core-shell structure may be formed by growing on a crystalized membrane spaced apart from a substrate having a cavity therebetween through metal organic chemical vapor deposition (MOCVD) as described below.

The membrane may serve as a seed layer for growth of the light-emitting layer 110. The membrane may relieve stress that may cause dislocation, together with the light-emitting layer 110 growing on the membrane, such that the light-emitting layer 110 growing on the membrane may have high quality having a low defect density.

A passivation layer 120 is provided on the light-emitting layer 110. Herein, the passivation layer 120 is provided to cover a surface of a light-emitting layer except for a portion 111a of the top surface of the first semiconductor layer 111 and a portion 112a of a bottom surface of the second semiconductor layer 112. Thus, the passivation layer 120 may be provided to cover an end portion of the active layer 113 exposed on the top surface of the light-emitting layer 110. Accordingly, light leaking from the end portion of the active layer 113 may be blocked, improving the efficiency of light extraction. The passivation layer 120 may include, e.g., a silicon oxide or a silicon nitride, but this is merely an example.

The first electrode 130 is provided to be electrically connected with the first semiconductor layer 111. More specifically, the first electrode 130 is provided on the passivation layer 120 to contact an opened surface of the first semiconductor layer 111. For instance, the portion 111a of the top surface of the first semiconductor layer 111 opened by not being covered with the passivation layer 120.

The first electrode 130 may include a transparent electrode. When the first semiconductor layer 111 includes, for example, an n-type nitride semiconductor, the first electrode 130 may include an n-type electrode. The first electrode 130 may include a transparent conductive material such as indium tin oxide (ITO), indium zinc oxide (IZO), etc. However, the disclosure is not limited to this example.

The second electrode 140 is provided to be electrically connected with the second semiconductor layer 112. More specifically, the second electrode 140 is provided on the passivation layer 120 to contact an opened surface of the second semiconductor layer 112. For example, the portion 112a of the bottom surface of the second semiconductor layer 112 opened by not being covered with the passivation layer 120.

The second electrode 140 may include a reflective electrode. When the second semiconductor layer 112 includes, for example, a n-type nitride semiconductor, the second electrode 140 may include a p-type electrode. The second electrode 140 may include a metal material having superior conductivity.

According to an example embodiment, upon application of a voltage to each of the first electrode 130 and the second electrode 140 in the LED device 100 structured as described above, electrons and holes combine in the active layer 113 of the light-emitting layer 110, thus generating light of a wavelength band and emitting the light outside the LED device 100. Herein, the light-emitting layer 110 may adjust a band gap according to a type of a material constituting the light-emitting layer 110, thus emitting light of a desired wavelength band. For example, the LED device 100 may emit red light, green light, or blue light by being applied as a pixel of the display apparatus.

The LED device 100 may include a micro-size LED device. More specifically, the LED device 100 may have, for example, a size of about 100 µm x 100 µm or less and a thickness of about 10 µm or less. However, the disclosure is not limited to this example.

According to an example embodiment of the disclosure, the light-emitting layer 110 may be grown on a crystalized membrane spaced apart from a substrate with a cavity therebetween, reducing stress that may be generated in the light-emitting layer 110 and thus improving the light-emitting layer 110 of high quality having low defect density. Hence, the LED device 100 may be implemented which has high efficiency and high reliability and improves the efficiency of light extraction. Moreover, the passivation layer 120 may be provided to cover the end portion of the active layer 113 on the top surface of the light-emitting layer 110, improving current injection characteristics and thus improving the efficiency of light extraction.

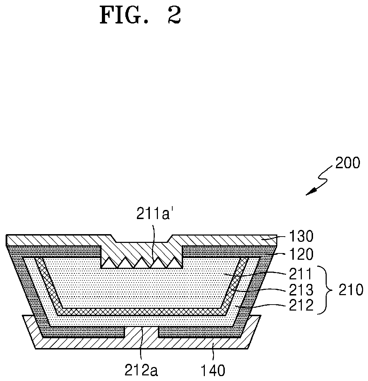

FIG. 2 is a cross-sectional view of an LED device manufactured according to another example embodiment. Hereinbelow, a description will be made focusing on the differences from the foregoing example embodiment.

Referring to FIG. 2, an LED device 200 includes a light-emitting layer 210 having a core-shell structure, a first electrode 130 provided above the light-emitting layer 210 and a second electrode 140 provided below the light-emitting layer 210. The light-emitting layer 210 includes a first semiconductor layer 211 having a 3D shape, an active layer 213 provided to cover a bottom surface and a side surface of the first semiconductor layer 211, and a second semiconductor layer 212 provided to cover the active layer 213.

According to an example embodiment, a passivation layer 120 is provided on the light-emitting layer 210. Herein, the passivation layer 120 is provided to cover a surface of the light-emitting layer 210 except for a portion of a top surface of the first semiconductor layer 211 and a portion 212a of a bottom surface of the second semiconductor layer 212.

The portion of the top surface of the first semiconductor layer 211 opened through the passivation layer 120 may include a convex-concave structure as a light extraction surface. Herein, the convex-concave structure may include a plurality of protrusions 211a' to improve light extraction. Each of the protrusions 211a' may have, for example, a polygonal horn shape or a cone shape. However, this is merely an example, such that each of the protrusions 211a' may have other various shapes.

According to the example embodiment, by forming a convex-concave structure on the portion of the top surface of the first semiconductor layer 211 as the light extraction surface, the efficiency of light extraction may be further improved.

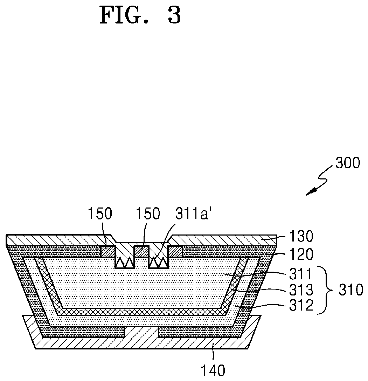

FIG. 3 is a cross-sectional view of an LED device manufactured according to another example embodiment. Hereinbelow, a description will be made focusing on the differences from the foregoing example embodiment.

Referring to FIG. 3, an LED device 300 includes a light-emitting layer 310 having a core-shell structure, a first electrode 130 provided above the light-emitting layer 210 and a second electrode 140 provided below the light-emitting layer 210. The light-emitting layer 310 includes a first semiconductor layer 311 having a 3D shape, an active layer 313 provided to cover a bottom surface and a side surface of the first semiconductor layer 311, and a second semiconductor layer 312 provided to cover the active layer 313.

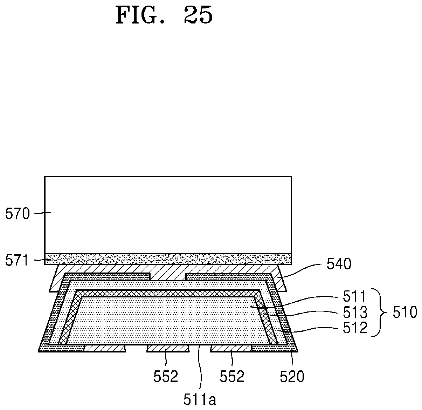

A passivation layer 120 is provided on the light-emitting layer 310. Herein, the passivation layer 120 is provided to cover a surface of a light-emitting layer except for a portion of the top surface of the first semiconductor layer 311 and a portion of a bottom surface of the second semiconductor layer 312. On the top surface opened through the passivation layer 120, a plurality of membranes 150 are provided to be spaced apart from each other, and top surfaces of the first semiconductor layer 311 are opened between the membranes 150. Herein, the membranes 150 are provided by a process illustrated in FIG. 25, which will be described later.

The portion of the top surface of the first semiconductor layer 311 opened between the membranes 150 may include a convex-concave structure as a light extraction surface. Herein, the convex-concave structure may include a plurality of protrusions 311a' to improve light extraction. However, the disclosure is not limited to this example, and as such, according to another example embodiment, the plurality of protrusions 311a' may not be provided.

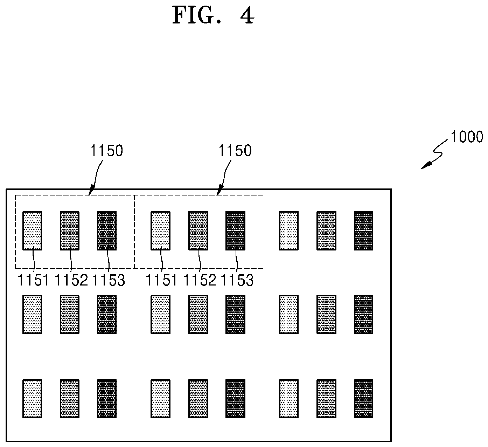

FIG. 4 is a plane view schematically illustrating a display apparatus comprising light emitting diode devices manufactured according to an example embodiment. A display apparatus 1000 illustrated in FIG. 4 may be, for example, a micro LED display apparatus. However, the disclosure is not limited to this example.

Referring to FIG. 4, the display apparatus 1000 may include a plurality of unit pixels 1150. In FIG. 1, nine unit pixels 1150 are illustrated for convenience, but the disclosure is not limited thereto. To implement a color image by using the display apparatus 1000, each of the plurality of unit pixels 1150 may include pixels of different colors. For example, each of the unit pixels 1150 may include a first pixel 1151, a second pixel 1152, and a third pixel 1153 having different colors. For example, the first pixel 1151, the second pixel 1152, and the third pixel 1153 may be a blue pixel, a green pixel, and a red pixel, respectively. However, the disclosure is not limited to this example.

The first pixel 1151, the second pixel 1152, and the third pixel 1153 may include a first LED device, a second LED device, and a third LED device emitting light of different wavelength bands, respectively. For example, when the first pixel 1151, the second pixel 1152, and the third pixel 1153 are a blue pixel, a green pixel, and a red pixel, respectively, the first LED device, the second LED device, and the third LED device may be a red LED device, a green LED device, and a blue LED device, respectively. The first LED device, the second LED device, and the third LED device may be the LED device 100, the LED device 200, and the third LED device according to the above-described embodiments, respectively, and thus will not be described in detail.

The first pixel 1151, the second pixel 1152, and the third pixel 1153 may include a plurality of LED devices that emit light of the same wavelength band. For example, when the first pixel 1151, the second pixel 1152, and the third pixel 1153 are a blue pixel, a green pixel, and a red pixel, respectively, the first pixel 1151, the second pixel 1152, and the third pixel 1153 may include blue LED devices, respectively. In this case, the second pixel 1152 that is the green pixel may further include a green conversion layer that converts blue light into green light, and the third pixel 1153 that is the red pixel may further include a red conversion layer that converts blue light into red light.

For example, when the first pixel 1151, the second pixel 1152, and the third pixel 1153 are a blue pixel, a green pixel, and a red pixel, respectively, the first pixel 1151, the second pixel 1152, and the third pixel 1153 may include ultra-violet LED devices, respectively. In this case, the first pixel 1151 that is the blue pixel may further include a blue conversion layer that converts ultra-violet rays into blue light, the second pixel 1152 that is the green pixel may further include a green conversion layer that converts ultra-violet rays into green light, and the third pixel 1153 that is the red pixel may further include a red conversion layer that converts ultra-violet rays into red light.

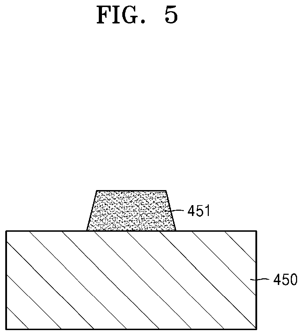

FIGS. 5 to 17 are diagrams for describing a method of manufacturing an LED device, according to an example embodiment.

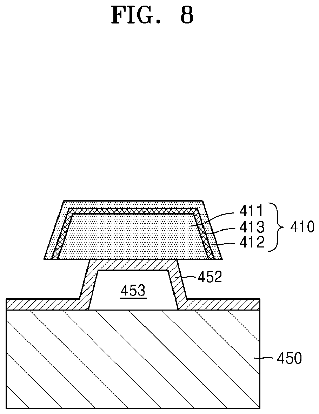

Referring to FIG. 5, a sacrificial pattern 451 is formed on a top surface of a substrate 450. Herein, when a light-emitting layer (410 of FIG. 8) described later includes a nitride semiconductor, the substrate 450 may include, for example, a sapphire substrate. However, this is merely an example, and the substrate 450 may include a silicon substrate, a silicon carbide (SiC) substrate, a gallium arsenide (GaAs) substrate, etc., and other various materials.

The sacrificial pattern 451 may include, for example, a photoresist, a nano-imprint resin, an organic nano particle, etc. The sacrificial pattern 451 may be formed using, a method such as a photolithography method, a nano-imprint method, organic nano-particle attachment, etc. The sacrificial pattern 451 may be formed in various forms as needed. For example, the sacrificial pattern 451 may be formed in a form extending in a direction or in other various forms.

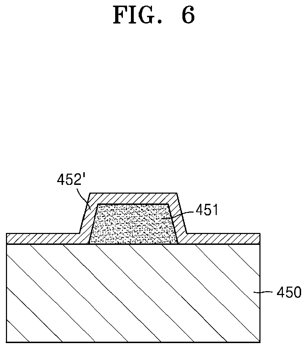

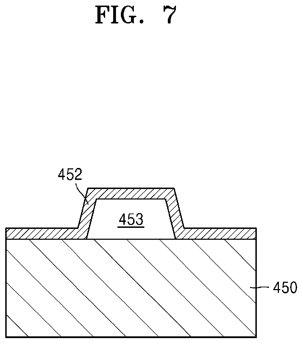

Referring to FIG. 6, a membrane material layer 452' is formed on the top surface of the substrate 450 to cover the sacrificial pattern 451. A membrane material layer 452' defines a cavity (453 of FIG. 7) with the substrate 450 therebetween in a subsequent process, and may be formed in a temperature range at which the sacrificial pattern 451 is not deformed. The membrane material layer 452' may be formed to a thickness such that the original shape of a structure is maintained stable after removal of the sacrificial pattern 451.

The membrane material layer 452' may be formed using various methods such as atomic layer deposition (ALD), wet synthesis, metal deposition and oxidation, sputtering, etc. In this case, the membrane material layer 452' may be formed in an amorphous form or in a polycrystal form of a fine particle.

The membrane material layer 452' may include, for example, alumina (Al₂O₃). However, this is merely an example, and the membrane material layer 452' may include silica (SiO₂), titania (TiO₂), zirconia (ZrO₂), yttria (Y₂O₃)-zirconia, copper oxide (CuO, Cu₂O), tantalum oxide (Ta₂O₅), aluminum nitride (AlN), silicon nitride (Si₃N₄), etc. However, the disclosure is not limited to this example.

Referring to FIG. 7, the sacrificial pattern 451 is selectively removed from the substrate 450. The sacrificial pattern 451 may be removed using heating, ashing, or an organic solvent. Once the sacrificial pattern 451 is removed, a cavity 453 defined by the substrate 450 and the membrane material layer 452' is formed.

As described above, the membrane material layer 452' is generally formed in an amorphous form or in a polycrystal form of a very small particle. After removal of the sacrificial pattern 451, the membrane material layer 452' may be crystalized through heat treatment, thus forming a membrane 452. Herein, leg parts of the membrane 452 may be provided on opposite sides of the cavity 453 to contact the substrate 450.

For example, when the substrate 450 and the membrane material layer 452' have the same composition as each other like when the substrate 450 includes a sapphire substrate and the membrane material layer 452' includes alumina, the membrane 452 is formed by crystalizing the membrane material layer 452' in the same crystal structure as the substrate 450 through heat treatment at about 1000°C. This is because, as solid phase epitaxy occurs in a part of the membrane material layer 452' which directly contacts the substrate 450 during high-temperature heat treatment, crystallization occurs in a crystallographic direction of the substrate 450.

The membrane 452 formed by crystallization may be formed in a polycrystal form including large particles or in a single crystal form. In a subsequent process, when an epitaxial layer of a nitride semiconductor grows, the membrane 452 on the cavity 453 serves as a seed layer and thus needs to be crystalized in advance.

Referring to FIG. 8, a first semiconductor layer 411, an active layer 413, and a second semiconductor layer 412 are sequentially grown on the membrane 452 above the cavity 453, thus forming a light-emitting layer 410. Herein, the first semiconductor layer 411, the active layer 413, and the second semiconductor layer 412 may be grown, for example, using chemical vapor deposition (CVD). More specifically, the first semiconductor layer 411, the active layer 413, and the second semiconductor layer 412 may be grown through organic metal CVD (metal organic CVD: MOCVD).

The light-emitting layer 410 is formed to have a core-shell structure. In this case, the first semiconductor layer 411 constitutes a core of a core-shell structure, and the active layer 413 and the second semiconductor layer 412 constitute a shell of the core-shell structure.

The first semiconductor layer 411, the active layer 413, and the second semiconductor layer 412, which constitute the light-emitting layer 410, may include, for example, a nitride semiconductor. Herein, the nitride semiconductor may include, but is not limited to, e.g., GaN, InN, AIN, or a combination thereof. By adjusting a band gap according to a type of a material constituting the light-emitting layer 410, light of a desired wavelength band may be emitted. For example, the light-emitting layer 410 may emit red light, green light, or blue light.

According to an example embodiment, the first semiconductor layer 411 may be grown on the membrane 452 above the cavity 453. The first semiconductor layer 411 may include, but is not limited to, an n-type nitride semiconductor. For example, the first semiconductor layer 411 may include n-GaN. The first semiconductor layer 411 may be formed in a 3D shape having a relatively thick thickness on the membrane 452 on the cavity 453 through adjustment of a growth time. The first semiconductor layer 411 may have a single-layer or multi-layer structure.

According to an example embodiment, the active layer 413 may be grown on the first semiconductor layer 411. The active layer 413 may be formed to cover the top surface and the side surface of the first semiconductor layer 411. The active layer 413 may generate light in a specific color through combination between electrons and holes and may have an MQW structure. However, the disclosure is not limited thereto, and depending on circumstances, the active layer 113 may have an SQW structure. For example, the active layer 113 may include GaN.

According to an example embodiment, the second semiconductor layer 412 may be grown on the active layer 413. The second semiconductor layer 412 may include, but is not limited to, a p-type nitride semiconductor. For example, the second semiconductor layer 412 may include p-GaN. The second semiconductor layer 412 may have a single-layer or multi-layer structure.

The membrane 452 may relieve stress that may cause dislocation, together with the light-emitting layer 410 growing on the membrane, such that the light-emitting layer 410 growing on the membrane may have high quality having a low defect density.

Generally, stress caused by a physical difference between a growth substrate and a thin film growing on the growth substrate may be converted into elastic energy on an interfacial surface and may become a driving force generating dislocation. In a related art case, the growth substrate has a much larger thickness than the thin film and thus is difficult to transform, such that dislocation is generated on the thin film and stress is relieved. But, when the thin film grows to a thickness or more, elastic energy on the interfacial surface becomes greater than generation energy of dislocation, such that dislocation starts to occur. However, as in the example embodiment, when the membrane 452 is thinner than the light-emitting layer 410, dislocation generation on the light-emitting layer 410 is reduced, such that the light-emitting layer 410 of high quality having low defect density may be formed.

In the example embodiment, due to existence of the cavity 453 between the substrate 450 and the light-emitting layer 410, stress energy may be consumed by the deformation of the cavity 453 even in spite of a difference in thermal expansion coefficient between the substrate 450 and the light-emitting layer 410, thus reducing thermal stress applied to the light-emitting layer 410 and also reducing bending of the substrate 450.

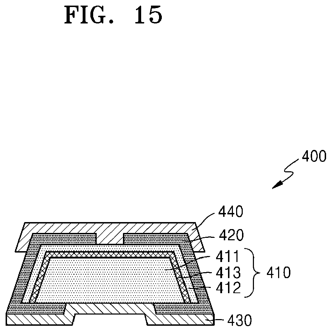

As such, the light-emitting layer 410 having superior physical properties may be formed on the membrane 452 on the cavity 453, thereby implementing an LED device (400 of FIG. 15) having high efficiency and high reliability and improving the efficiency of light extraction.

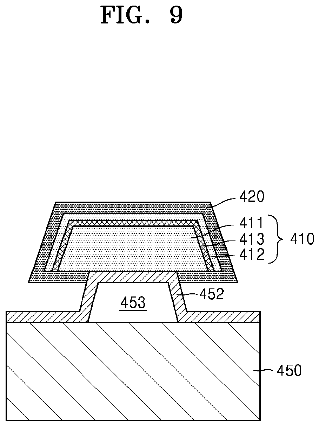

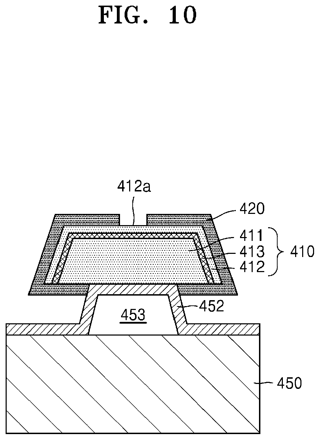

Referring to FIG. 9, a passivation layer 420 is formed on the surface of the light-emitting layer 410. Herein, the passivation layer 420 is formed to cover the first semiconductor layer 411, the active layer 413, and a surface of the second semiconductor layer 412. The passivation layer 420 may be formed by depositing, for example, silicon oxide or silicon nitride on the surface of the light-emitting layer 410 by using, for example, atomic layer deposition (ALD) or CVD. Referring to FIG. 10, by etching a top portion of the passivation layer 420, a portion 412a of a top surface of the second semiconductor layer 412 is opened.

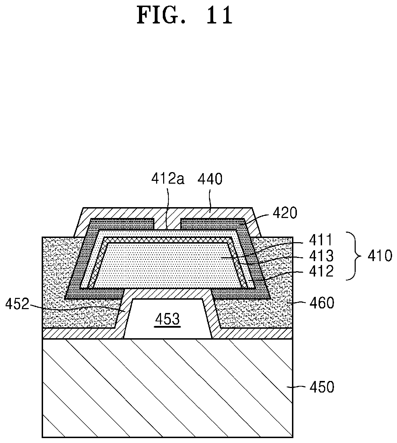

Referring to FIG. 11, a photoresist 460 is formed on the substrate 450 and is patterned to open the top portion of the passivation layer 420. Then, a second electrode 440 is formed on the passivation layer 420 to contact the opened portion 412a of the second semiconductor layer 412. Herein, the second electrode 440 may include a reflective electrode. When the second semiconductor layer 412 includes a p-type nitride semiconductor, the second electrode 440 may include a p-type electrode. The second electrode 440 may be formed by depositing a metal material having superior conductivity on a top surface of the passivation layer 420 by using, for example, electron beam deposition, etc. Thereafter, the photoresist 460 may be removed.

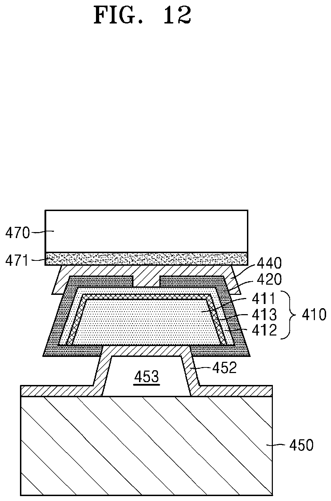

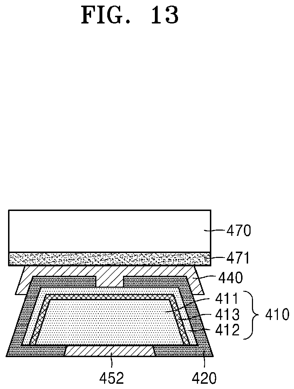

Referring to FIG. 12, an adhesive layer 471 of a separation member 470 is adhered onto a top surface of the second electrode 440. Next, referring to FIG. 13, by applying a mechanical force to the separation member 470, leg parts of the membrane 452 may collapse, thus separating the light-emitting layer 410 from the substrate 450. In this case, as shown in FIG. 13, the membrane 452 on a bottom surface of the first semiconductor layer 411 remains as it is.

The substrate 450 and the light-emitting layer 410 are connected by the membrane 452 with each other, having the cavity 453 therebetween. Herein, the leg parts of the membrane 452 may collapse merely with a small mechanical force, such that the light-emitting layer 410 may be easily separated from the substrate 450 without being damaged.

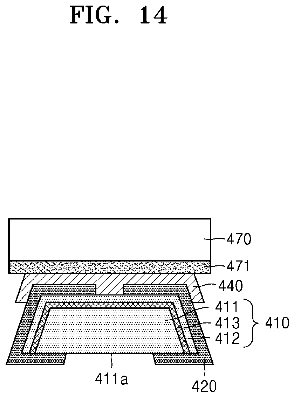

Referring to FIG. 14, the membrane 452 remaining on the bottom surface of the first semiconductor layer 411 is removed. For example, when the membrane 452 includes alumina, the membrane 452 may be removed by phosphoric acid (H₃PO₄), but this is merely an example. As the membrane 452 is removed, a portion 411a of the bottom surface of the first semiconductor layer 411 is opened. The separation member 470 may be detached from the second electrode 440.

Referring to FIG. 15, a first electrode 430 is formed on a bottom surface of the passivation layer 420 to contact the opened portion 411a of the first semiconductor layer 411. Thus, an LED device 400 may be completed. Herein, the first electrode 430 may include a transparent electrode. When the first semiconductor layer 411 includes an n-type nitride semiconductor, the first electrode 430 may include an n-type electrode. The first electrode 430 may be formed by depositing a transparent conductive material such as ITO, IZO, etc., on the bottom surface of the passivation layer 420 by using, for example, electron beam deposition, etc.

The LED device 400 completed as described above may have, for example, a size of about 100 µm × 100 µm or less and a thickness of about 10 µm or less. However, this is merely an example.

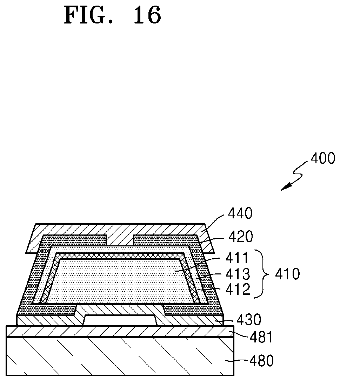

Referring to FIG. 16, under the LED device 400, a transparent substrate 480 with a transparent electrode 481 thereon may be provided. According to an example embodiment, the transparent electrode 481 may be deposited on the transparent substrate 480. The transparent electrode 481 may be provided to be electrically connected with the first electrode 430. Herein, when a plurality of LED devices 400 are manufactured, the transparent electrode 481 may serve as a common electrode that electrically connects the first electrodes 430.

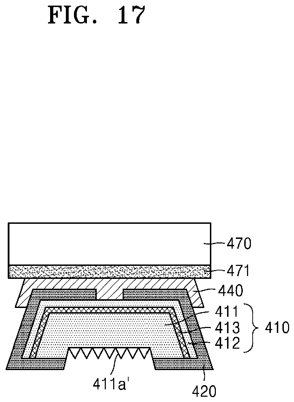

According to another example embodiment, after the opened portion 411a of the first semiconductor layer 411 is formed as described above in FIG. 14, a concave-convex structure for improving the efficiency of light extraction may be formed on the opened portion 411a of the first semiconductor layer 411 as shown in FIG. 17. Herein, the concave-convex structure may include a plurality of protrusions 411a', each of which may have, but are not limited to, a polygonal horn shape or a cone shape. The concave-convex structure may be formed by wet etching the exposed portion 411a of the first semiconductor layer 411 by using, for example, tetramethylammonium chloride (TMAH), potassium hydroxide (KOH), etc.

According to the example embodiment, the light-emitting layer 410 grows on the membrane 452 spaced apart from the substrate 450 with the cavity 453 therebetween, such that the LED device 400 having high quality with low defect density may be manufactured. As the light-emitting layer 410 may be easily separated from the substrate 450 merely with a small mechanical force without being damaged, the features illustrated in the various example embodiments of the disclosure may be useful for an application field needing separation between the substrate 450 and the light-emitting layer 410, for example, manufacturing of an LED device having a vertical-type electrode structure. Moreover, as the exposed end portion of the active layer 413 may be covered with the passivation layer 420 on a light extraction surface of the light-emitting layer 410, the efficiency of light extraction may be further improved.

Hereinbelow, a description will be made of a method of manufacturing an LED device having a larger size than the LED device 400 manufactured according to the foregoing embodiment.

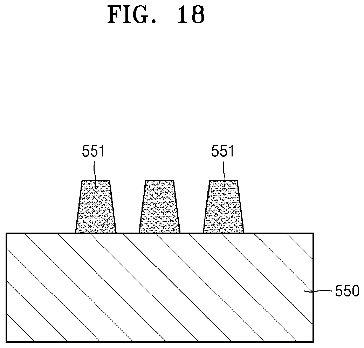

FIGS. 18 to 31 are diagrams for describing a method of manufacturing an LED device, according to another example embodiment.

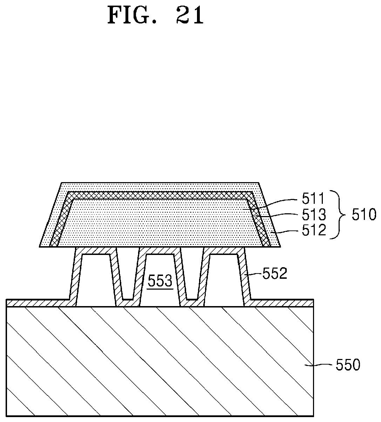

Referring to FIG. 18, a plurality of sacrificial patterns 551 are formed on a top surface of a substrate 550. FIG. 18 shows a case where three sacrificial patterns 551 are formed on a top surface of the substrate 550, but the disclosure is not limited thereto. Herein, when a light-emitting layer (510 of FIG. 21) described later includes a nitride semiconductor, the substrate 550 may include, for example, a sapphire substrate. The sacrificial patterns 551 may be formed in various forms by using, for example, a photolithography method, a nano-imprint method, organic nano particle attachment, etc.

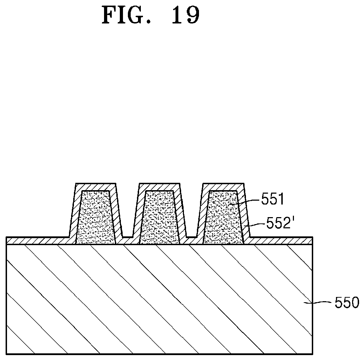

Referring to FIG. 19, a membrane material layer 552' is formed on a top surface of the substrate 550 to cover the sacrificial patterns 551. The membrane material layer 552' may be formed by using, for example, ALD, wet synthesis, metal deposition and oxidation, sputtering, etc. In this case, the membrane material layer 552' may be formed in an amorphous form or in a polycrystal form of a fine particle. For example, when the substrate 550 includes a sapphire substrate, the membrane material layer 552' may include alumina (Al₂O₃).

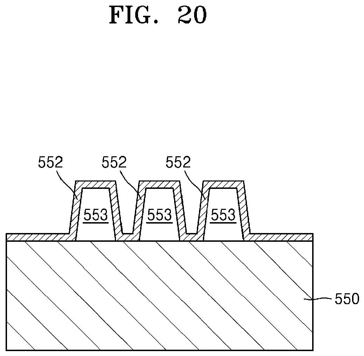

Referring to FIG. 20, the sacrificial patterns 551 are selectively removed from the substrate 550. Once the sacrificial patterns 551 are removed, cavities 553 defined by the substrate 550 and the membrane material layer 552' are formed.

After removal of the sacrificial pattern 551, the membrane material layer 552' is crystalized through heat treatment, thus forming a plurality of membranes 552 corresponding to the cavities 553. FIG. 20 shows a case where three cavities 553 and three membranes 552 corresponding to three sacrificial patterns 551 are formed. The membrane 552 formed by crystallization may be formed in a polycrystal form including large particles or in a single crystal form. On opposite sides of each of the cavities 553, leg parts of the membrane 552 may be provided to contact the substrate 550.

Referring to FIG. 21, a first semiconductor layer 511, an active layer 513, and a second semiconductor layer 512 are sequentially grown on the membranes 552 on the cavities 553, thus forming a light-emitting layer 510. Herein, for example, the first semiconductor layer 511, the active layer 513, and the second semiconductor layer 512 may be grown through MOCVD, but is not limited thereto.

The light-emitting layer 510 is formed to have a core-shell structure. In this case, the first semiconductor layer 511 constitutes a core of a core-shell structure, and the active layer 513 and the second semiconductor layer 512 constitute a shell of the core-shell structure. The first semiconductor layer 511, the active layer 513, and the second semiconductor layer 512, which constitute the light-emitting layer 510, may include, for example, a nitride semiconductor. By adjusting a band gap according to a type of a material constituting the light-emitting layer 510, light of a desired wavelength band may be emitted.

According to an example embodiment, the first semiconductor layer 511 may be grown on the membranes 552 on the cavities 553. Herein, by adjusting a growth time, nitride semiconductors grow on the three membranes 552, respectively, and are connected with each other, thus forming the first semiconductor layer 511. The first semiconductor layer 511 has a 3D shape by being formed to a relatively thick thickness. The first semiconductor layer 511 may include, but is not limited to, an n-type nitride semiconductor.

According to an example embodiment, the active layer 513 may be grown on the first semiconductor layer 511. The active layer 513 may be formed to cover the top surface and the side surface of the first semiconductor layer 511. The second semiconductor layer 512 may grow on the active layer 513. The second semiconductor layer 512 may include, but is not limited to, a p-type nitride semiconductor.

The membranes 552 together with the light-emitting layer 510 growing on the membranes 552 may relieve stress that may cause dislocation, such that the light-emitting layer 510 growing on the membranes 552 may have high quality with low defect density. As the cavity 553 is between the substrate 550 and the light-emitting layer 510, thermal stress applied to the light-emitting layer 510 may be reduced.

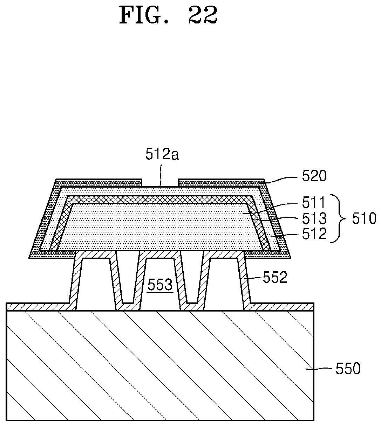

Referring to FIG. 22, a passivation layer 520 is formed on the surface of the light-emitting layer 510. Herein, the passivation layer 520 is formed to cover the first semiconductor layer 511, the active layer 513, and a surface of the second semiconductor layer 512. The passivation layer 520 may be formed by, for example, ALD or CVD. Herein, the passivation layer 520 may not be formed on the bottom surface of the first semiconductor layer 511 between the membranes 552. However, the disclosure is not limited to this example, such that depending on a deposition method, the passivation layer 520 may also be formed on the bottom surface of the first semiconductor layer 511 between the membranes 552. Next, by etching a top portion of the passivation layer 520, a portion 512a of the top surface of the second semiconductor layer 512 is opened.

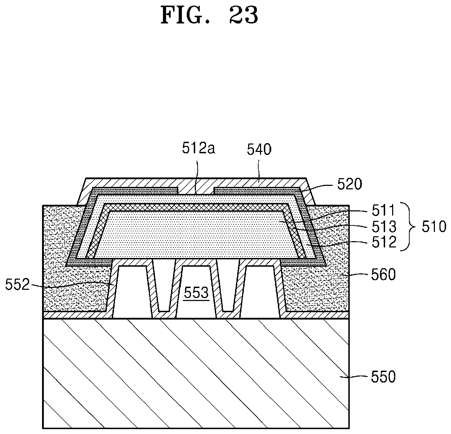

Referring to FIG. 23, a photoresist 560 is formed on the substrate 550 and is patterned to open the top portion of the passivation layer 520. Then, a second electrode 540 is formed on the passivation layer 520 to contact the opened portion 512a of the second semiconductor layer 512. Herein, the second electrode 540 may include a reflective electrode. When the second semiconductor layer 512 includes a p-type nitride semiconductor, the second electrode 540 may include a p-type electrode. Thereafter, the photoresist 560 may be removed.

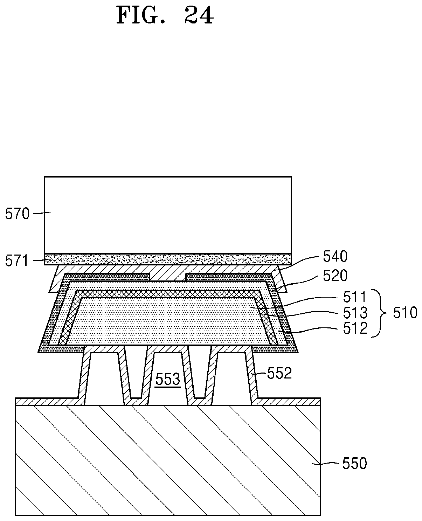

Referring to FIG. 24, an adhesive layer 571 of a separation member 570 is adhered onto a top surface of the second electrode 540. Next, referring to FIG. 25, by applying a mechanical force to the separation member 570, leg parts of the membranes 552 may collapse, thus separating the light-emitting layer 510 from the substrate 550. In this case, the membranes 552 on the bottom surface of the first semiconductor layer 511 may remain as they are. Thus, portions 511a of the bottom surface of the first semiconductor layer 511 between the membranes 552 may be exposed outside.

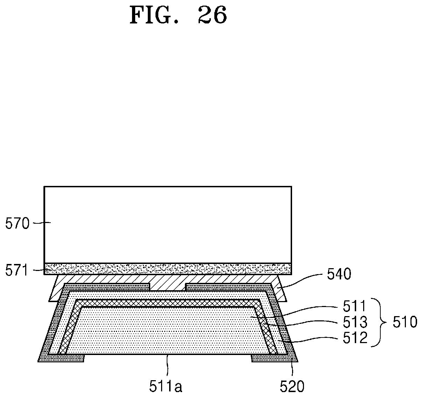

Referring to FIG. 26, the membrane 552 remaining on the bottom surface of the first semiconductor layer 511 is removed. As the membrane 552 is removed, the portions 511a of the bottom surface of the first semiconductor layer 511 is opened. The separation member 570 may be detached from the second electrode 540.

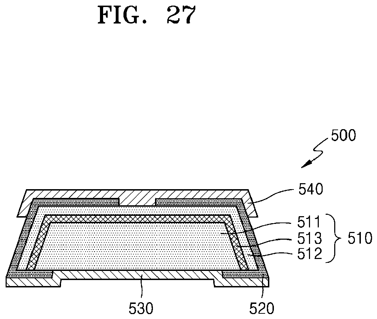

Referring to FIG. 27, a first electrode 530 is formed on a bottom surface of the passivation layer 520 to contact the opened portions 511a of the first semiconductor layer 511. Thus, an LED device 500 may be completely manufactured. Herein, the first electrode 530 may include a transparent electrode. When the first semiconductor layer 511 includes an n-type nitride semiconductor, the first electrode 530 may include an n-type electrode.

In the example embodiment, the light-emitting layer 510 may be grown by using the plurality of membranes 552, thus manufacturing the LED device 500 having a larger size than the LED device 400 manufactured according to the above-described example embodiment.

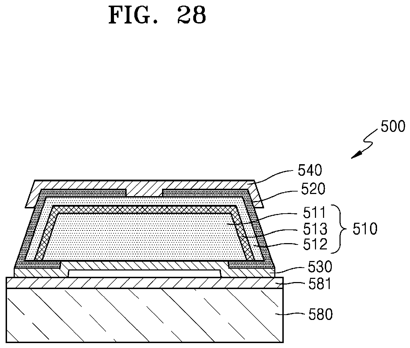

Referring to FIG. 28, under the LED device 500, a transparent substrate 580 with a transparent electrode 581 may be provided. According to an example embodiment, the transparent electrode 581 may be deposited on the transparent substrate 580. The transparent electrode 581 may be provided to be electrically connected with the first electrode 530. Herein, when a plurality of LED devices 500 are manufactured, the transparent electrode 581 may serve as a common electrode that electrically connects the first electrodes 530.

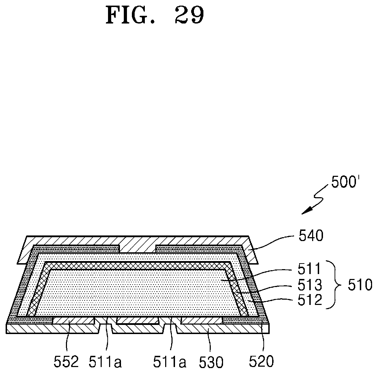

According to another example embodiment, With reference to FIG. 25, it has been described that the membranes 552 on the bottom surface of the first semiconductor layer 511 remain as they are, such that the portions 511a of the bottom surface of the first semiconductor layer 511 between the membranes 552 are opened. Next, referring to FIG. 29, the first electrode 530 may be formed on the bottom surface of the passivation layer 520 to contact the opened portions 511a of the first semiconductor layer 511, thus manufacturing the LED device 500'.

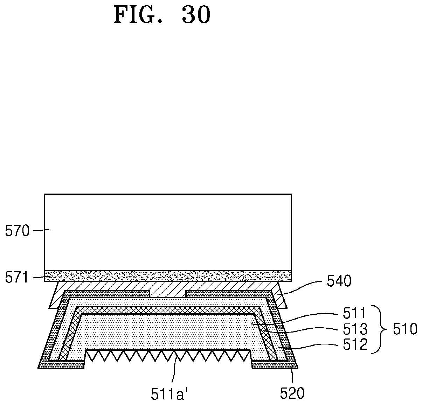

According to another example embodiment, after the opened portions 511a of the first semiconductor layer 511 are formed as described above in FIG. 26, a concave-convex structure for improving the efficiency of light extraction may be formed on the opened portions 511a of the first semiconductor layer 511 as shown in FIG. 30. Herein, the concave-convex structure may include a plurality of protrusions 511a'. The concave-convex structure may be formed by wet etching the opened portions 511a of the first semiconductor layer 511.

After the portions 511a of the bottom surface of the first semiconductor layer 511 between the membranes 552 are opened as shown in FIG. 25, the concave-convex structure for improving the efficiency of light extraction may be formed on each of the opened portions 511a of the first semiconductor layer 511.

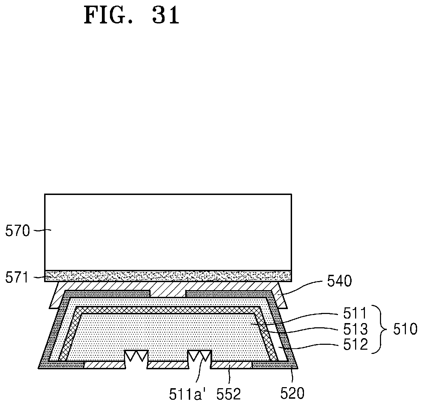

According to another example embodiment, with reference to FIG. 25, it has been described that the membranes 552 on the bottom surface of the first semiconductor layer 511 remain as they are, such that the portions 511a of the bottom surface of the first semiconductor layer 511 between the membranes 552 are opened. Next, referring to FIG. 31, a concave-convex structure for improving the efficiency of light extraction may be formed on each of the opened portions 511a of the first semiconductor layer 511. Herein, the concave-convex structure may include a plurality of protrusions 511a'. The concave-convex structure may be formed by wet etching the opened portions 511a of the first semiconductor layer 511.

According to the foregoing example embodiments, it may be possible to reduce stress that may be generated in the light-emitting layer due to growth of the light-emitting layer on the crystalized membrane spaced apart from the substrate with the cavity therebetween, thereby forming the light-emitting layer of high quality with low defect density. Therefore, the LED device may be implemented which has high efficiency and high reliability and improves the efficiency of light extraction. Moreover, the passivation layer is provided to cover the end portion of the active layer on the top surface of the light-emitting layer, thereby improving current injection characteristics and thus improving the efficiency of light extraction. Furthermore, by forming the concave-convex structure on the top surface of the light-emitting layer that is the light extraction surface, the efficiency of light extraction may be further enhanced. While the foregoing embodiments of the disclosure have been described, it will be apparent to those of ordinary skill in the art that these are examples and various modifications may be made therefrom, as long as they remain within the scope of the invention which is defined by the appended claims.

## Claims

1. An assembly for manufacturing a light-emitting diode (LED), comprising:
a substrate (450);
a membrane material layer (452') formed on top of the substrate so as to define a cavity (453) between the membrane material layer and the substrate;
a light-emitting layer (410) comprising a first semiconductor layer (411), an active layer (413), and a second semiconductor layer (412), the light-emitting layer having a core-shell structure, wherein:
the first semiconductor layer is provided in a three-dimensional, 3D, shape having a relatively thick thickness compared to the active layer and the second semiconductor layer, the first semiconductor layer being the core of the core-shell structure,
the active layer is provided to cover a top surface and a side surface of the first semiconductor layer, and
the second semiconductor layer is provided on the active layer, and wherein the first semiconductor layer is provided on the membrane above the cavity;
a passivation layer (420) provided to cover the light emitting layer (410); and
a second electrode (440) provided on a second side of the light-emitting layer to contact the second semiconductor layer.

2. The assembly of claim 1, wherein the passivation layer (420) is provided to cover an entire side surface of the light-emitting layer (410), a first portion of the top surface of the first semiconductor layer (411), and a first portion of a bottom surface of the second semiconductor layer (412).

3. The assembly of any preceding claim, wherein the first semiconductor layer (411), the active layer (413), and the second semiconductor layer (412) comprise nitride semiconductor materials.

4. A method of manufacturing a light-emitting diode, LED, device (100), the method comprising:
forming a membrane (452) on a substrate (450), wherein the forming of the membrane comprises:
forming a sacrificial pattern (451) on the substrate;
forming a membrane material layer (452') on the substrate to cover the sacrificial pattern; and
crystalizing the membrane material layer;
forming a light-emitting layer (410) having a core-shell structure by sequentially depositing on the membrane, a first semiconductor layer (411) in a three-dimensional, 3D, shape, an active layer (413) covering a top surface and a side surface of the first semiconductor layer, and a second semiconductor layer (412) covering the active layer, the first semiconductor layer being the core of a core-shell structure and having a relatively thick thickness compared to the active layer and the second semiconductor layer;
forming a passivation layer (420) to cover the light-emitting layer;
forming a first opening (412a) in the passivation layer at a portion of a top surface of the light-emitting layer by etching the passivation layer; and
forming a first electrode (430) and a second electrode (440), which contact the first semiconductor layer and the second semiconductor layer, respectively, and **characterized in that** forming the membrane comprises:
removing the sacrificial pattern, thereby forming a cavity (453) between the membrane material layer and the substrate.

5. The method of claim 4, further comprising:
forming a second opening (411a) in the passivation layer (420) at a portion of a bottom surface of the first semiconductor layer (411) by removing the membrane (452).

6. The method of claim 5, further comprising forming a concave-convex structure (411a') on the second portion of the bottom surface of the first semiconductor layer (411), before forming the first electrode (430).

## Patentansprüche

1. Baugruppe zur Herstellung einer Leuchtdiode (LED), umfassend:
ein Substrat (450);
eine Membranmaterialschicht (452'), die auf der Oberseite des Substrats gebildet ist, um einen Hohlraum (453) zwischen der Membranmaterialschicht und dem Substrat zu definieren;
eine lichtemittierende Schicht (410), die eine erste Halbleiterschicht (411), eine aktive Schicht (413) und eine zweite Halbleiterschicht (412) umfasst, wobei die lichtemittierende Schicht eine Kern-Schale-Struktur aufweist, wobei:
die erste Halbleiterschicht in einer dreidimensionalen Form, 3D-Form, bereitstellt ist, die eine relativ große Dicke im Vergleich zu der aktiven Schicht und der zweiten Halbleiterschicht aufweist, wobei die erste Halbleiterschicht den Kern der Kern-Schale-Struktur darstellt,
die aktive Schicht bereitgestellt ist, um eine obere Fläche und eine Seitenfläche der ersten Halbleiterschicht zu bedecken, und
die zweite Halbleiterschicht auf der aktiven Schicht bereitgestellt ist und wobei die erste Halbleiterschicht auf der Membran über dem Hohlraum bereitgestellt ist,
eine Passivierungsschicht (420), die bereitgestellt ist, um die lichtemittierende Schicht (410) zu bedecken, und
eine zweite Elektrode (440), die auf einer zweiten Seite der lichtemittierenden Schicht bereitgestellt ist, um die zweite Halbleiterschicht zu berühren.

2. Baugruppe nach Anspruch 1, wobei die Passivierungsschicht (420) bereitgestellt ist, um eine gesamte Seitenfläche der lichtemittierenden Schicht (410), einen ersten Abschnitt der oberen Fläche der ersten Halbleiterschicht (411) und einen ersten Abschnitt einer unteren Fläche der zweiten Halbleiterschicht (412) zu bedecken.

3. Baugruppe nach einem der vorhergehenden Ansprüche, wobei die erste Halbleiterschicht (411), die aktive Schicht (413) und die zweite Halbleiterschicht (412) Nitridhalbleitermaterialien umfassen.

4. Verfahren zur Herstellung einer Leuchtdioden-Vorrichtung, LED-Vorrichtung, (100), wobei das Verfahren Folgendes umfasst:
Bilden einer Membran (452) auf einem Substrat (450), wobei das Bilden der Membran Folgendes umfasst:
Bilden eines Opfermusters (451) auf dem Substrat,
Bilden einer Membranmaterialschicht (452') auf dem Substrat, um das Opfermuster abzudecken; und
Kristallisieren der Membranmaterialschicht;
Bilden einer lichtemittierenden Schicht (410), die eine Kern-Schale-Struktur aufweist, durch aufeinanderfolgendes Abscheiden einer ersten Halbleiterschicht (411) in einer dreidimensionalen Form, 3D-Form, einer aktiven Schicht (413), die eine obere Fläche bedeckt, und einer Seitenfläche der ersten Halbleiterschicht und einer zweiten Halbleiterschicht (412), welche die aktive Schicht bedeckt, auf der Membran, wobei die erste Halbleiterschicht den Kern einer Kern-Schale-Struktur darstellt und im Vergleich zu der aktiven Schicht und der zweiten Halbleiterschicht eine relativ große Dicke aufweist,
Bilden einer Passivierungsschicht (420), um die lichtemittierende Schicht abzudecken;
Bilden einer ersten Öffnung (412a) in der Passivierungsschicht an einem Abschnitt einer oberen Fläche der lichtemittierenden Schicht durch Ätzen der Passivierungsschicht; und
Bilden einer ersten Elektrode (430) und einer zweiten Elektrode (440), die jeweils die erste Halbleiterschicht und die zweite Halbleiterschicht berühren, und **dadurch gekennzeichnet, dass** das Bilden der Membran Folgendes umfasst:
Entfernen des Opfermusters, wodurch ein Hohlraum (453) zwischen der Membranmaterialschicht und dem Substrat gebildet wird.

5. Verfahren nach Anspruch 4, ferner umfassend:
Bilden einer zweiten Öffnung (411a) in der Passivierungsschicht (420) an einem Abschnitt einer unteren Fläche der ersten Halbleiterschicht (411) durch Entfernen der Membran (452).

6. Verfahren nach Anspruch 5, ferner umfassend Bilden einer konkav-konvexen Struktur (411a') auf dem zweiten Abschnitt der unteren Fläche der ersten Halbleiterschicht (411) vor dem Bilden der ersten Elektrode (430).

## Revendications

1. Ensemble destiné à la fabrication d'une diode électroluminescente (DEL), comprenant :
un substrat (450) ;
une couche de matériau membranaire (452') formée sur le dessus du substrat de façon à définir une cavité (453) entre la couche de matériau membranaire et le substrat ;
une couche électroluminescente (410) comprenant une première couche semi-conductrice (411), une couche active (413) et une seconde couche semi-conductrice (412), la couche électroluminescente comportant une structure coeur-enveloppe,
ladite première couche semi-conductrice étant prévue sous une forme tridimensionnelle, 3D, comportant une épaisseur relativement épaisse par rapport à la couche active et à la seconde couche semi-conductrice, la première couche semi-conductrice étant le coeur de la structure coeur-enveloppe,
ladite couche active étant prévue pour recouvrir une surface supérieure et une surface latérale de la première couche semi-conductrice, et
la seconde couche semi-conductrice étant prévue sur la couche active, et ladite première couche semi-conductrice étant prévue sur la membrane au-dessus de la cavité ;
une couche de passivation (420) prévue pour recouvrir la couche électroluminescente (410) ; et
une seconde électrode (440) prévue sur un second côté de la couche électroluminescente pour entrer en contact avec la seconde couche semi-conductrice.

2. Ensemble de la revendication 1, ladite couche de passivation (420) étant prévue pour recouvrir une surface latérale entière de la couche électroluminescente (410), une première partie de la surface supérieure de la première couche semi-conductrice (411), et une première partie d'une surface inférieure de la seconde couche semi-conductrice (412).

3. Ensemble d'une quelconque revendication précédente, ladite première couche semi-conductrice (411), ladite couche active (413) et ladite seconde couche semi-conductrice (412) comprenant des matériaux semi-conducteurs au nitrure.

4. Procédé de fabrication d'un dispositif à diodes électroluminescentes, DEL, (100), le procédé comprenant :
la formation d'une membrane (452) sur un substrat (450), ladite formation de la membrane comprenant :
la formation d'un motif sacrificiel (451) sur le substrat ;
la formation d'une couche de matériau membranaire (452') sur le substrat pour recouvrir le motif sacrificiel ; et
la cristallisation de la couche de matériau membranaire ;
la formation d'une couche électroluminescente (410) comportant une structure coeur-enveloppe en déposant séquentiellement sur la membrane, une première couche semi-conductrice (411) selon une forme tridimensionnelle, 3D, une couche active (413) recouvrant une surface supérieure et une surface latérale de la première couche semi-conductrice, et une seconde couche semi-conductrice (412) recouvrant la couche active, la première couche semi-conductrice étant le coeur d'une structure coeur-enveloppe et comportant une épaisseur relativement épaisse par rapport à la couche active et à la seconde couche semi-conductrice ;
la formation d'une couche de passivation (420) pour recouvrir la couche électroluminescente ;
la formation d'une première ouverture (412a) dans la couche de passivation au niveau d'une partie d'une surface supérieure de la couche électroluminescente par gravure de la couche de passivation ; et
la formation d'une première électrode (430) et d'une seconde électrode (440), qui sont respectivement en contact avec la première couche semi-conductrice et la seconde couche semi-conductrice, et **caractérisé en ce que** la formation de la membrane comprend :
le retrait du motif sacrificiel, formant ainsi une cavité (453) entre la couche de matériau de membrane et le substrat.

5. Procédé de la revendication 4, comprenant en outre :
la formation d'une seconde ouverture (411a) dans la couche de passivation (420) au niveau d'une partie d'une surface inférieure de la première couche semi-conductrice (411) en retirant la membrane (452).

6. Procédé de la revendication 5, comprenant en outre la formation d'une structure concave-convexe (411a') sur la seconde partie de la surface inférieure de la première couche semi-conductrice (411), avant de former la première électrode (430).
